# EUROPEAN PATENT APPLICATION

(11) **EP 4 708 335 A1**
(43) Date of publication of application: **11.03.2026**
(21) Application number: 25195558.9
(22) Date of filing: 13.08.2025
(51) Int. Cl.: H01C 1/148, H01C 7/102, H01C 7/12, H01H 37/76, H01T 1/14, H01C 1/14, H01T 1/12

(54) **VOLTAGE LIMITER WITH AN INTEGRATED SHORT-CIRCUITING DEVICE AND A FUNCTIONAL STATUS MONITORING DEVICE**

(30) Priority: 27.08.2024 CZ 20240323
(71) Applicant: SALTEK s.r.o., 40007 Usti nad Labem, Krasne Brezno (CZ)
(72) Inventor: Suchy, Jaromir, 40340 Usti nad Labem, Skorotice (CZ); Stejskal, Petr, 40323 Velke Brezno (CZ); Toman, Vladimir, 41181 Brozany nad Ohri (CZ); Vykydal, Jiri, 26724 Hostomice (CZ); Zacek, Miroslav, 40011 Usti nad Labem, Severni Terasa (CZ)
(74) Representative: Tomickova, Dana

(57) **Abstract**

A voltage limiter (1) with an integrated short-circuiting device and a functional status monitoring device comprises a housing (2) with an internal cavity (20), a first connecting terminal (3) and a second connecting terminal (4) that lead out of the housing (2), and a short-circuiting device disposed inside the housing (2). The short-circuiting device comprises a protective element (5), a movable electrode (6), a fixed electrode (7), and at least one fusible element (8) connecting the protective element (5) to the movable electrode (6) or the fixed electrode (7). The voltage limiter (1) further comprises a functional status monitoring device that comprises at least one sensor from a group comprising a position sensor (11) indicating the position of the movable electrode (6), a pressure sensor (12) indicating the pressure in the internal cavity (20) of the housing (2), and a temperature sensor (13) indicating the temperature on the external surface or inside the housing (2). The functional status monitoring device further comprises an evaluation unit (17) connected to at least one sensor and adapted to provide information about the functional status of the voltage limiter (1).

## Description

### Technical Field

The present invention relates to a device that enhances the reliability of voltage limiters equipped with a short-circuiting device and allows checking and signaling their functional status, thereby enhancing their safety and operational reliability.

### Background of the Invention

In the current state of the art, a wide range of solutions is known that address the bridging of a protective element in the event of its overload by excessive current. For example, in the document US3755715 titled A "LINE PROTECTOR HAVING ARRESTER AND FAIL-SAFE CIRCUIT BYPASSING THE ARRESTER", a solution of a surge arrester for telecommunications is described that has a gas discharge tube as the primary protective element and an air gap having a higher arc voltage than the gas discharge tube as the secondary protective element. Excessive current passing through the secondary spark gap fuses the pellet and the spring force moves the short-circuiting housing so as to connect the opposite conductors. The arrangement does not allow to check the functional status other than by measurement.

Another document WO2016045982 A1, or (EP3198692 A1) "OVERVOLTAGE PROTECTION ASSEMBLY HAVING A SHORT-CIRCUITING DEVICE" relates to a surge protection assembly comprising a two-part metal housing, a surge arrester, and, further, a short-circuiting device consisting of two opposite contact electrodes which are under mechanical preload and can perform relative movement with respect to each other by means of a spring force in the event of a short circuit. The contact electrodes are separated by an element which, in the event of heating of the surge arrester, enables relative movement of the contact electrodes. The surge arrester is composed of a varistor, or a varistor and a gas discharge tube connected in series. A disadvantage of this solution is that it does not allow checking the functional status other than by disassembly and subsequent measurement.

The short-circuiting device according the invention EP1458072 A1 "SHORT-CIRCUIT DEVICE TO BE USED IN LOW AND MEDIUM VOLTAGE ARRANGEMENTS" comprises a switching element, e.g., a gas discharge tube, a spark gap, a thyristor, etc., which is disposed between two electrically conductive electrodes. One of the electrodes is movable and is acted upon by a preloaded compression spring and is connected to the input lead. The other electrode is fixed and is connected to protective ground. An insulating gap is provided between the two electrodes. The protective element may be connected to the electrodes by means of an element having a defined fusible integral, which is destroyed in the event of an overload and thereby enables the movable electrode's position to be changed and a short circuit to form. The device according to the cited invention does not allow checking of the functional status other than by disassembly and subsequent measurement.

The document WO2019220171 A1 "VOLTAGE LIMITER WITH A SHORT-CIRCUITING DEVICE" describes the technical solution of a voltage limiter with an internal short-circuiting device. The limiter comprises a housing with an internal cavity and output leads leading out of the housing and electrically connected to the protective element. The short-circuiting device is composed of fixed and movable parts. The fixed part of the short-circuiting device has a cylindrical electrically conductive contact disposed in the cavity of the housing. The movable part consists of an electrically conductive short-circuiting element that is connected to the contact at a contact surface via a fusible element. The short-circuiting element is provided with a stop at its upper end, against which a preloaded spring rests with its upper end. The spring rests with its bottom end against the output lead. The short-circuiting element is geometrically adapted to bridge the distance between the short-circuiting element and the output lead in case of thermal or impulse overload. The device according to the cited invention does not allow checking of the functional status other than by disassembly and subsequent measurement.

Therefore, it would be desirable to come up with a solution that would allow checking of the functional status of the voltage limiter equipped with a short-circuiting device with a movable electrode, i.e., determining whether a short circuit of the short-circuiting device has occurred without having to disassemble the voltage limiter in any way.

### Summary of the Invention

The above shortcomings are eliminated to a certain extent by a voltage limiter with an integrated short-circuiting device and a functional status monitoring device, wherein the voltage limiter comprises a housing with an internal cavity, a first connecting terminal and a second connecting terminal that lead out of the housing, and a short-circuiting device disposed inside the housing. The short-circuiting device comprises a protective element, a movable electrode, a fixed electrode, and at least one fusible element connecting the protective element to the movable electrode or the fixed electrode. The protective element is electrically conductively connected to the first connecting terminal and the second connecting terminal, the movable electrode is electrically conductively connected to the first connecting terminal, and the fixed electrode is electrically conductively connected to the second connecting terminal. The movable electrode is movable relative to the fixed electrode between a first position in which the movable electrode and the fixed electrode are mutually separated by an insulating gap and a second position in which the movable electrode and the fixed electrode are in mutual contact.

The individual components of the voltage limiter may be implemented differently as long as its general arrangement as described in the paragraph above is maintained.

Preferably, e.g., the housing may have the shape of a hollow cylinder provided with closing faces on opposite sides with openings for the passage of the first connecting terminal or the second connecting terminal. This means that the first connecting terminal and the second connecting terminal lead out of the housing through these openings. Alternatively, however, the first connecting terminal and the second connecting terminal may lead out of the housing such that the first connecting terminal or the second connecting terminal is part of the housing and extends directly outwards from the material of the housing. Alternatively, the housing may also have a non-cylindrical shape.

Preferably, the housing is formed of an electrically conductive material, e.g., stainless steel, which provides high resistance to the effects of the external environment and high resistance to internal overpressure. If the housing is made of an electrically conductive material, preferably at least one of the electrodes is insulated from the connecting terminal connected thereto by an insulating insert made of an electrically nonconductive material. Alternatively, the housing may be formed of an electrically nonconductive material, e.g., a plastic with a high resistance to temperature, or ceramic, glass, or a combination of these materials. Then the connecting terminals can lead out of the housing in a non-insulated way and the insulating insert does not need to be used.

The electrical conductive connection between the movable electrode and the first connecting terminal and the electrical conductive connection between the fixed electrode and the second connecting terminal may be implemented, e.g., such that the first connecting terminal may be formed as part of the movable electrode and the second connecting terminal may be formed as part of the fixed electrode. Alternatively, the respective connecting terminals and the respective electrodes may be implemented as separate components that are electrically conductively connected by another electrically conductive element. If, e.g., the first connecting terminal is an integral part of the housing, the movable electrode may be connected to the housing, e.g., via at least one movable conductor. Typically, when using a voltage limiter, the fixed electrode is electrically conductively connected via the second connecting terminal to the protective ground, while the movable electrode is electrically conductively connected via the first connecting terminal to the protected object. However, it can also be the other way around and the fixed electrode may be connected to the protected object.

Preferably, the movable electrode and the fixed electrode have the shape of a hollow cylinder with one face and are disposed in the housing inversely opposite to each other so as to define a space between them for housing the protective element and the at least one fusible element. Alternatively, however, they may also have a different shape, wherein the dimensions and shape of the movable electrode and the fixed electrode may be chosen with respect to the dimensions and shape of the protective element used. Alternatively, e.g., only one of the electrodes may have the shape of a hollow cylinder with a single face, while the other electrode may have the shape of a solid cylinder.

The movement of the movable electrode relative to the housing (and thus also the movement of the movable electrode relative to the fixed electrode, since the latter is immovable relative to the housing) is preferably provided by means of an elastic element that acts on the movable electrode with a force that moves the movable electrode away from the corresponding side of the housing, i.e., away from the face out of which the first connecting terminal leads. This force thus tends to bring the movable electrode closer to the fixed electrode, but this bringing closer is prevented by the at least one fusible element, as will be described below. The elastic element may, e.g., be a preloaded helical compression spring, or a spring made of wire with shape memory, or at least one flat spring, etc. The elastic element also serves to maintain electrically conductive contact between the individual components.

The electrically conductive connection between the protective element and the first connecting terminal and the second connecting terminal is implemented by the movable electrode, or the fixed electrode, and the at least one fusible element that connects the protective element to at least one of the electrodes, i.e., the movable electrode, the fixed electrode, or both. Preferably, the short-circuiting device of the voltage limiter comprises two fusible elements disposed individually between the corresponding electrode and protective element. The fusible elements preferably have the shape of a flat solid cylinder, but alternatively may have other shapes with respect to the shape of the electrodes or the protective element, e.g., the shape of a flat cylinder with a base in the shape of an annulus. Alternatively, the voltage limiter may comprise only one fusible element that connects the protective element to the movable electrode or that connects the protective element to the fixed electrode.

The height of the at least one fusible element may be selected with respect to the dimensions of the protective element such that the movable electrode is separated from the fixed electrode by a sufficient insulating gap. A sufficient insulating gap means a gap with dielectric strength higher than the static ignition voltage of the protective element. The protective element may be, e.g., at least one varistor, at least one varistor connected in series to a gas discharge tube, at least one gas discharge tube, or at least one spark gap.

In the case of a thermal or current load of the voltage limiter, the protective element generates a large amount of heat causing the temperature of the at least one fusible element to rise rapidly to its liquid temperature (melting temperature) and cause it to melt. Preferably, the fusible elements are formed from a tin alloy having a melting temperature between 140 °C and 270 °C. Alternatively, however, they may be made of another suitable material. After melting of the at least one fusible element, the movable electrode is displaced from the first position to the second position in which the movable electrode is in contact with the fixed electrode, thus creating an alternate current path that bridges the protective element and prevents its explosion or other uncontrollable failure. The first position thus corresponds to the functional status of the voltage limiter, where there is no overload of the protective element or in other words where there is no short circuit of the short-circuiting device ("OK" status). On the other hand, the second position corresponds to the functional status of the voltage limiter, where there is an overload of the protective element 5 and there is a short circuit of the short-circuiting device ("NOK" status). In this functional status, the voltage limiter may no longer be used to protect the protected object and must be replaced.

However, when the voltage limiter is overloaded, there is also a pressure increase in the internal cavity and a temperature increase inside and outside the housing, wherein a short circuit of the short-circuiting device occurs when the pressure in the internal cavity exceeds a certain value, or when the temperature on the external surface or inside the housing exceeds a certain value.

The essence of the voltage limiter of the present invention lies in the fact that the voltage limiter further comprises a functional status monitoring device, wherein the functional status monitoring device comprises at least one sensor from a group comprising a position sensor indicating the position of the movable electrode, a pressure sensor indicating the pressure in the internal cavity of the housing, and a temperature sensor indicating the temperature on the external surface or inside the housing. The functional status monitoring device further comprises an evaluation unit connected to the at least one sensor and adapted to provide information about the functional status of the voltage limiter based on the output of the at least one sensor, wherein the information about the functional status of the voltage limiter is information about whether an overload of the protective element and a short circuit of the short-circuiting device have occurred.

The main advantage of the present invention lies in the fact that it allows checking of the functional status of the voltage limiter equipped with the short-circuiting device with the movable electrode. This makes it possible to determine whether or not an overload of the protective element and a short circuit of the short-circuiting device have occurred without the need to disassemble the voltage limiter in any way.

The above problem of checking the functional status of the voltage limiter may be solved by three methods, using the three different sensors mentioned above, wherein the similar nature of these solutions lies in the fact that the given sensor always determines whether or not an overload of the protective element and a short circuit of the short-circuiting device have occurred. However, it is possible for the functional status monitoring device to comprise multiple sensors from the group listed above in any combination. The combination of multiple different sensors provides a higher reliability of the checking of the functional status of the voltage limiter. The device may also comprise multiple sensors of the same type, e.g., two temperature sensors, one indicating the temperature inside the housing (e.g., on its internal surface or directly in the internal cavity) and the other indicating the temperature on the external surface of the housing. The outputs of all the used sensors are connected to the input of the evaluation unit.

Preferably, the functional status monitoring device comprises at least one position sensor indicating the position of the movable electrode, at least one pressure sensor indicating the pressure in the internal cavity of the housing, and at least one temperature sensor indicating the temperature on the external surface or inside the housing. Thus, preferably all three types of sensors are used for checking the functional status of the voltage limiter, which further increases the reliability of the checking of the functional status of the voltage limiter. In that case, the functional status monitoring device may comprise only one evaluation unit that comprises at least one input for connecting the position sensor, at least one input for connecting the pressure sensor, and at least one input for connecting the temperature sensor. Alternatively, the functional status monitoring device may comprise multiple evaluation units, e.g., one evaluation unit for each sensor.

The position sensor is preferably connected to the movable electrode by a link between the position sensor and the movable electrode. The link between the position sensor and the movable electrode allows to transmit the movement of the movable electrode to the movement of a part of the position sensor, preferably to the movement of its contacts, thus changing their status, or to the movement that the position sensor can detect. The link between the position sensor and the movable electrode may be implemented as a mechanical link, e.g., as a rod or lever, or it may be implemented as a magnetic link using a magnet, wherein the contacts of the position sensor are controlled magnetically. Alternatively, other embodiments or modifications of the link between the position sensor and the movable electrode are also possible, provided that the link allows the position sensor to indicate the position of the movable electrode, e.g., via the first connecting terminal.

The position sensor may indicate the position of the movable electrode by measuring the change thereof. Alternatively, the position sensor may measure the absolute value of the position of the movable electrode, e.g., relative to the fixed electrode or relative to a prominent point on the housing. In general, however, based on the output of the position sensor (whether this output is the measured signal, the status of the contacts, etc.), the evaluation unit provides information about the functional status of the voltage limiter, i.e., information about whether an overload of the protective element and a short circuit of the short-circuiting device have occurred. For example, the contacts of the position sensor may be connected in the "Normal Open" mode, i.e., if the input of the evaluation unit to which the output of the position sensor is connected is in a high impedance ("Open") status, the output of the evaluation unit is information that the functional status of the voltage limiter is "OK". If, on the other hand, the input of the evaluation unit to which the output of the position sensor is connected is in a low impedance ("Closed") status, the output of the evaluation unit is information that the functional status of the voltage limiter is "NOK". Alternatively, however, the contacts of the position sensor may be connected in the opposite "Normal Closed" mode.

The pressure sensor is preferably connected to the internal cavity by means of an outlet, which allows reliable measurement of the pressure in the internal cavity of the housing. The outlet may be introduced into the housing through an opening preferably formed at approximately 1/2 and 1/3 of the height of the housing. Alternatively the pressure may be measured at another location of the internal cavity.

The pressure sensor may indicate the pressure in the internal cavity preferably by comparing the pressure in the internal cavity to a predetermined reference value and outputting information as to whether the value of the pressure in the internal cavity is above or below this reference value, e.g., by changing the status of the contacts of the pressure sensor. The contacts of the pressure sensor may be connected, e.g., in the "Normal Open" mode, i.e., if the input of the evaluation unit to which the output of the pressure sensor is connected is in a high impedance ("Open") status, the output of the evaluation unit is information that the functional status of the voltage limiter is "OK". If, on the other hand, the input of the evaluation unit to which the output of the pressure sensor is connected is in a low impedance ("Closed") status, the output of the evaluation unit is information that the functional status of the voltage limiter is "NOK". Alternatively, however, the contacts of the pressure sensor may be connected in the opposite "Normal Closed" mode.

In general, however, based on the output of the pressure sensor, whether this output is the status of the contacts or the measured signal that can be further processed by the evaluation unit, the evaluation unit provides information about the functional status of the voltage limiter, i.e., information about whether an overload of the protective element and a short circuit of the short-circuiting device have occurred.

Preferably, the temperature sensor is a thermal fusible fuse. The thermal fusible fuse is connected to the input of the evaluation unit with its output leads at the output and can be connected to the external or internal surface of the housing with its output leads at the input. The fusing temperature of the fusible fuse at which the current path is interrupted is chosen to be approximately the same as the fusing temperature of the at least one fusible element, or slightly lower with respect to the arrangement of the voltage limiter. At the moment of a short circuit the temperature on the external or internal surface of the housing will be slightly lower than the temperature inside the housing, e.g., in the space between the movable electrode and the fixed electrode. Alternatively, the temperature sensor may be implemented differently, e.g., as a bimetal temperature switch, or a switch with a shape memory metal. Alternatively, the temperature sensor may be implemented as a temperature sensor that measures the temperature directly in the internal cavity of the housing.

The temperature sensor thus outputs information about whether the temperature on the external surface or inside the housing has exceeded a certain value that corresponds to a short circuit of the short-circuiting device. When this value is exceeded, the input of the evaluation unit changes, e.g., such that if the input of the evaluation unit to which the output of the temperature sensor is connected is in a low impedance ("Closed") status, the output of the evaluation unit is information that the functional status of the voltage limiter is "OK". If, on the other hand, the input of the evaluation unit to which the output of the temperature sensor is connected is in a high impedance ("Open") status, the output of the evaluation unit is information that the functional status of the voltage limiter is "NOK". Alternatively, however, the contacts of the temperature sensor may be connected in the opposite "Normal Open" mode.

Preferably, the evaluation unit comprises a transmitter for providing information about the functional status of the voltage limiter, wherein the functional status monitoring device further comprises a reader for receiving the information about the functional status of the voltage limiter provided by the transmitter. The reader preferably comprises a status indicator, e.g., a light or display on which the information about the functional status is displayed. Alternatively, the evaluation unit, or the evaluation unit and the reader, may comprise the status indicator. Alternatively, the functional status monitoring device does not have to comprise a reader if it already provides information about the functional status in other ways, e.g., by means of the display, light, or other status indicator. Alternatively, another device may be used instead of the reader, to which the evaluation unit is communicatively connected (either wirelessly or via data or analogue lines).

The evaluation unit preferably comprises an RFID chip and the reader preferably is an RFID reader. This allows checking of the functional status of the voltage limiters at low cost. Preferably, the evaluation unit is a microcontroller comprising the RFID chip. Alternatively, the evaluation unit may be implemented differently, e.g., it comprises an NFC chip (in which case the reader would be an NFC reader), a microprocessor, or an integrated circuit. The evaluation unit may further contain additional information in its memory, such as a unique identification number, installation date, allocation, etc.

### Description of Drawings

A summary of the invention is further clarified using exemplary embodiments thereof, which are described with reference to the accompanying drawings, in which:
fig. 1a schematically shows the voltage limiter of the first exemplary embodiment in section with the position sensor and the movable electrode in the first position,
fig. 1b schematically shows the voltage limiter of the first exemplary embodiment in section with the position sensor and the movable electrode in the second position corresponding to a short circuit of the short-circuiting device,
fig. 2 schematically shows the voltage limiter of the first exemplary embodiment with the position sensor, evaluation unit, and reader.
fig. 3 schematically shows the voltage limiter of the second exemplary embodiment in section with the pressure sensor,
fig. 4 schematically shows the voltage limiter of the second exemplary embodiment with the pressure sensor, evaluation unit, and reader,
fig. 5 schematically shows the voltage limiter of the third exemplary embodiment in section with the temperature sensor,
fig. 6 schematically shows the voltage limiter of the third exemplary embodiment with the temperature sensor, evaluation unit, and reader,
fig. 7 schematically shows the voltage limiter of the fourth exemplary embodiment in section with the position sensor, pressure sensor, and temperature sensor,
fig. 8 schematically shows the voltage limiter of the fourth exemplary embodiment with the position sensor, pressure sensor, temperature sensor, evaluation unit, and reader,
fig. 9 shows the short-circuiting device of an alternative exemplary embodiment of the voltage limiter, where the movable electrode has the shape of a hollow cylinder with one face and the fixed electrode has the shape of a solid cylinder and where the fusible elements have the shape of a flat solid cylinder,
fig. 10 shows the short-circuiting device of an alternative exemplary embodiment of the voltage limiter, where the movable electrode has the shape of a hollow cylinder with one face and the fixed electrode has the shape of a solid cylinder and where the fusible elements have the shape of a flat cylinder with a base in the shape of an annulus.

### Exemplary Embodiments of the Invention

The invention will be further clarified using exemplary embodiments with reference to the respective drawings.

### Example 1:

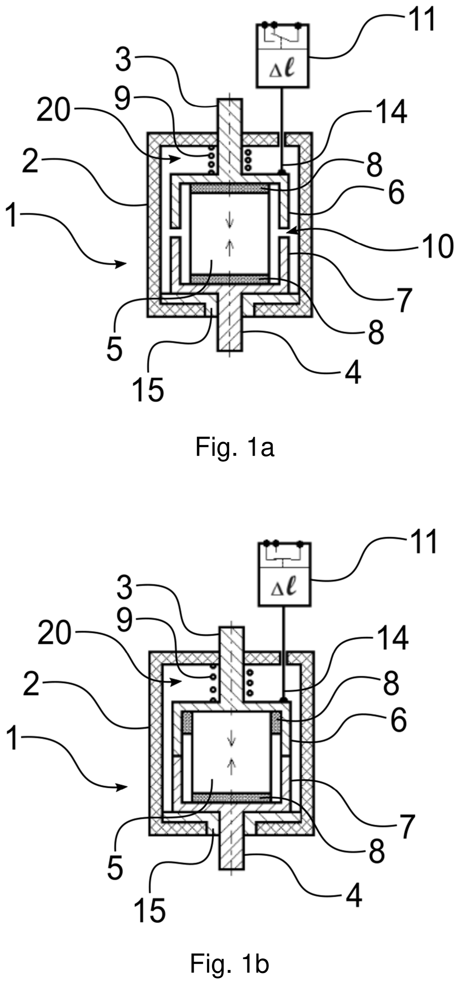

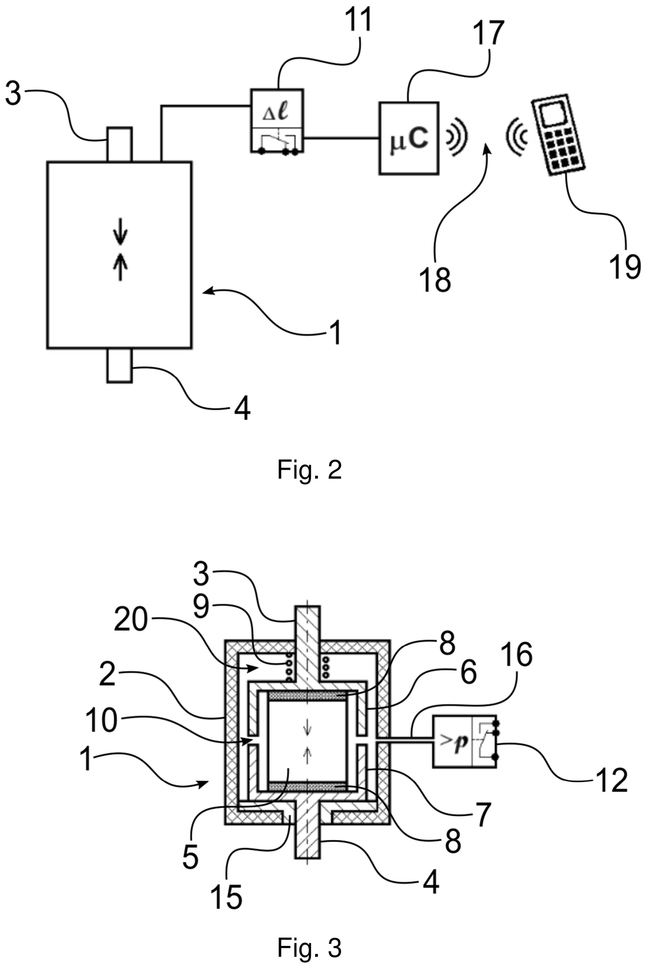

In the first exemplary embodiment shown in fig. 1a, fig. 1b, and fig. 2, a voltage limiter 1 comprises a housing 2 having an internal cavity 20, further, a first connecting terminal 3 and a second connecting terminal 4 that lead out of the housing 2, a short-circuiting device disposed within the housing 2, a position sensor 11 and an evaluation unit 17 connected to the position sensor 11. The position sensor 11 and the evaluation unit 17 together form a functional status monitoring device, wherein for the sake of maintaining logical continuity of the text, the voltage limiter 1 itself will be described in detail first without this device and this device will be described subsequently.

In the described first exemplary embodiment of the voltage limiter 1, the housing 2 has the shape of a hollow cylinder provided with closing faces on opposite sides with openings for the passage of the first connecting terminal 3 or the second connecting terminal 4. As an example, the housing 2 is formed of an electrically conductive material, e.g., stainless steel, which provides high resistance to the effects of the external environment and also high resistance to internal overpressure.

In this exemplary embodiment, the short-circuiting device comprises a protective element 5, a movable electrode 6, a fixed electrode 7, two fusible elements 8, and an elastic element 9. The movable electrode 6 is formed from a single piece of material together with the first connecting terminal 3, which ensures that the movable electrode 6 is electrically conductively connected to the first connecting terminal 3. The movement of the movable electrode 6 relative to the housing 2 is provided by the elastic element 9, which is, e.g., a preloaded helical compression spring. Thus, the elastic element 9 exerts a force on the movable electrode 6 that moves the movable electrode 6 away from the corresponding side of the housing 2, i.e., from the face out of which the first connecting terminal 3 leads. Since the movable electrode 6 and the first connecting terminal 3 are made of one piece of material, the first connecting terminal 3 is also inserted into the housing 2 during this movement.

By analogy, the fixed electrode 7 is formed from a single piece of material together with the second connecting terminal 4, which ensures that the fixed electrode 7 is electrically conductively connected to the second connecting terminal 7. However, unlike the movable electrode 6, the fixed electrode 7 is firmly connected to the housing 2. This means that the movement of the movable electrode 6 relative to the housing 2 also causes the movement of the movable electrode 6 relative to the fixed electrode 7, as will be further described below. There is also an insulating insert 15 of electrically nonconductive material between the fixed electrode 7 and the housing 2, which is adjacent to the face of the housing 2 and which electrically insulates the fixed electrode 7 and the associated second connecting terminal 4 from the housing 2. As an example, when using the voltage limiter 1, the fixed electrode 7 is electrically conductively connected via the second connecting terminal 4 to the protective ground, while the movable electrode 6 is electrically conductively connected via the first connecting terminal 3 to the protected object.

The movable electrode 6 and the fixed electrode 7 both have the shape of a hollow cylinder with one face and, as shown in fig. 1a and fig. 1b, they are disposed in the housing inversely opposite to each other so as to define a space between them for accommodating the protective element 5 and the two fusible elements 8. The dimensions and shape of the movable electrode 6 and the fixed electrode 7 are chosen with respect to the dimensions and shape of the protective element 5 used.

Specifically, the first fusible element 8 is disposed between the face of the movable electrode 6 and the protective element 5, and the second fusible element 8 is disposed between the face of the fixed electrode 7 and the protective element 5. Thus, the first fusible element 8 connects the protective element 5 to the movable electrode 6 and enables the electrically conductive connection of the protective element 5 to the first connecting terminal 3 and the second fusible element 8 connects the protective element 5 to the fixed electrode 7 and enables the electrically conductive connection of the protective element 5 to the second connecting terminal 4. In the exemplary embodiment described, the two fusible elements 8 have the shape of a flat solid cylinder and their axial axes merge with the axial axes of the movable electrode 6 and the fixed electrode 7.

The height of the fusible elements 8 is chosen with respect to the dimensions of the protective element 5 such that the movable electrode 6 is separated from the fixed electrode 7 by a sufficient insulating gap 10, as can be seen in fig. 1a. A sufficient insulating gap 10 means a gap with dielectric strength higher than the static ignition voltage of the protective element 5.

In the case of a thermal or current load of the voltage limiter 1, the protective element 5 generates a large amount of heat causing the temperature of the at least one fusible element 8 to rise rapidly to its liquid temperature (melting temperature) and cause it to melt. As an example, the fusible elements 8 are formed from a tin alloy with a melting temperature between 140 °C and 270 °C. The action of the elastic element 9 subsequently results in the displacement of the movable electrode 6 into contact with the fixed electrode 7, as shown in fig. 1b. This creates an alternate current path that bridges the protective element 5 and prevents its explosion or other uncontrollable failure. In order to partially decompress the pressure and reduce the possibility of explosion, a free space is also provided in the internal cavity 20 of the voltage limiter 1.

Thus, two basic positions of the movable electrode 6 relative to the fixed electrode 7 are defined. The first position of fig. 1a, in which the movable electrode 6 and the fixed electrode 7 are mutually separated by the insulating gap 10, corresponds to the functional status of the voltage limiter 1, where there is no overload of the protective element 5 or in other words where there is no short circuit of the short-circuiting device. This functional status of the voltage limiter 1 shall be referred to as "OK". The second position of fig. 1b, in which the movable electrode 6 and the fixed electrode 7 are in mutual contact, corresponds to the functional status of the voltage limiter 1, where overload of the protective element 5 and a short circuit of the short-circuiting device occur. This functional status of the voltage limiter 1 shall be referred to as "NOK". In this functional status, the voltage limiter 1 may no longer be used to protect the protected object and must be replaced.

As indicated above, the functional status monitoring device is used to monitor the functional status of the voltage limiter 1, which in the first exemplary embodiment comprises a position sensor 11 and an evaluation unit 17 associated with the position sensor 11.

The position sensor 11 indicates the position of the movable electrode 6, by being adapted to measure the position of the movable electrode 6. This adaptation lies in the fact that it is connected to the movable electrode 6 via a link 14 between the position sensor 11 and the movable electrode 6. This link 14 between the position sensor 11 and the movable electrode 6 is, for example, a mechanical link, specifically, e.g., a rod, which is connected to the contacts of the position sensor 11 and thus transmits the movement of the movable electrode 6 to the contacts of the position sensor 11, thereby changing their status. For this purpose, an opening for the passage of the rod is also created in the housing 2. Specifically, in the described exemplary embodiment, the position sensor 11 measures the change of the position of the movable electrode 6, as also indicated by the designation "ΔI" in fig. 1a, fig. 1b, and fig. 2.

The output of the position sensor 11 is connected to the input of the evaluation unit 17, which is in the first described exemplary embodiment a microcontroller. In this exemplary embodiment, the microcontroller comprises an RFID chip with at least one input for connecting at least the position sensor 11, and further also comprises a transmitter that provides information about the functional status of the voltage limiter 1, i.e., whether an overload of the protective element 5 and a short circuit of the short-circuiting device have occurred. The information about the functional status is obtained based on the signal from the position sensor 11 or, in other words, based on the output of the position sensor 11. As an example, the microcontroller is programmed such that when its input, to which the output of the position sensor 11 is connected, is in a high impedance status ("Open" status), the output of the microcontroller is information that the functional status of the voltage limiter 1 is "OK". If, on the other hand, its input, to which the output of the position sensor 11 is connected, is in a low impedance status ("Closed" status), the output of the microcontroller is information that the functional status of the voltage limiter 1 is "NOK", which means that overload of the protective element 5 and a short circuit of the short-circuiting device have occurred.

The received information about the functional status of the voltage limiter 1 is provided by the transmitter for its reception. In the exemplary embodiment, a reader 19 is used to receive this information, specifically an RFID reader, which is also shown in fig. 2 for greater clarity. In this exemplary embodiment, the reader 19 is connected to the evaluation unit 17 via a wireless connection 18, wherein the reader 19 comprises at least one status indicator, e.g., a light, for displaying the functional status of the voltage limiter 1 to the user.

### Example 2:

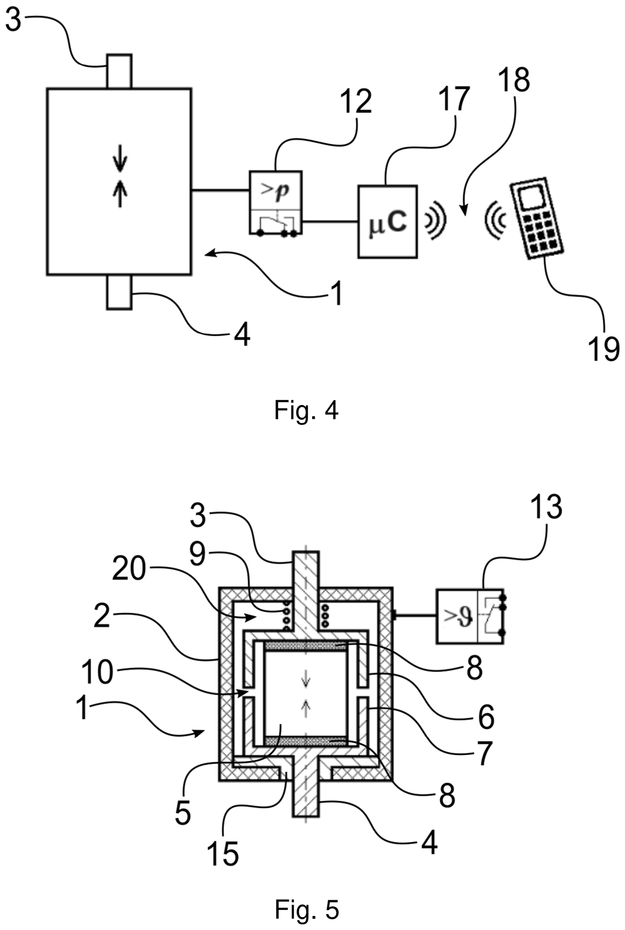

In the second exemplary embodiment shown in fig. 3 and fig. 4, the voltage limiter 1 is implemented in the same manner as in the first exemplary embodiment, with the difference that, instead of the position sensor 11, it comprises a pressure sensor 12, wherein the evaluation unit 17 is connected to this pressure sensor 12. Thus, the pressure sensor 12 and the evaluation unit 17 together form the functional status monitoring device.

The pressure sensor 12 indicates the pressure in the internal cavity 20 of the housing 2, by being adapted to measure the pressure in the internal cavity 20 of the housing 2. As an example, this adaptation lies in the fact that the pressure sensor 12 is connected to the internal cavity 20 via an outlet 16. For this purpose, an opening for the passage of the outlet 16 is formed in the housing 2. As an example, this opening is formed at approximately 1/2 to 1/3 of the height of the housing 2. Specifically, in the described exemplary embodiment, the pressure sensor 12 compares the pressure in the internal cavity 20 with a predetermined reference value and outputs information as to whether the pressure value in the internal cavity 20 is above this reference value. This is also indicated by the ">p" designation in fig. 3 and fig. 4.

In the case of a thermal or current load of the voltage limiter 1, the protective element 5 generates a large amount of heat causing the temperature of the at least one fusible element 8 to rise rapidly to its liquid temperature (melting temperature) and cause it to melt. The action of the elastic element 9 subsequently results in the displacement of the movable electrode 6 into contact with the fixed electrode 7, and thus in the creation of an alternate current path that bridges the protective element 5 and thus prevents its explosion or other uncontrollable failure. When the voltage limiter 1 is overloaded, the pressure in the internal cavity 20 also rises above the reference value, which causes the contacts of the pressure sensor 12 to switch from a status corresponding to the functional status of the voltage limiter 1 "OK" to a status corresponding to the functional status of the voltage limiter 1 "NOK". In this functional status, the voltage limiter 1 may no longer be used to protect the protected object and must be replaced.

The output of the pressure sensor 12 is connected to the input of the evaluation unit 17, which is in the described exemplary embodiment a microcontroller. In this exemplary embodiment, the microcontroller comprises an RFID chip with at least one input for connecting at least the pressure sensor 12, and further also comprises a transmitter that provides information about the functional status of the voltage limiter 1, i.e., whether an overload of the protective element 5 and a short circuit of the short-circuiting device have occurred. The information about the functional status is obtained based on the signal from the pressure sensor 12 or, in other words, based on the output of the pressure sensor 12. As an example, the microcontroller is programmed such that when its input, to which the output of the pressure sensor 12 is connected, is in a high impedance status ("Open" status), the output of the microcontroller is information that the functional status of the voltage limiter 1 is "OK". If, on the other hand, its input, to which the output of the pressure sensor 12 is connected, is in a low impedance status ("Closed" status), the output of the microcontroller is information that the functional status of the voltage limiter 1 is "NOK", which means that overload of the protective element 5 and a short circuit of the short-circuiting device have occurred.

The received information about the functional status of the voltage limiter 1 is provided by the transmitter for its reception. In the exemplary embodiment, a reader 19 is used to receive this information, specifically an RFID reader, which is also shown in fig. 4 for greater clarity. In this exemplary embodiment, the reader 19 is connected to the evaluation unit 17 via a wireless connection 18, wherein the reader 19 comprises at least one status indicator, e.g., a light, for displaying the functional status of the voltage limiter 1 to the user.

### Example 3:

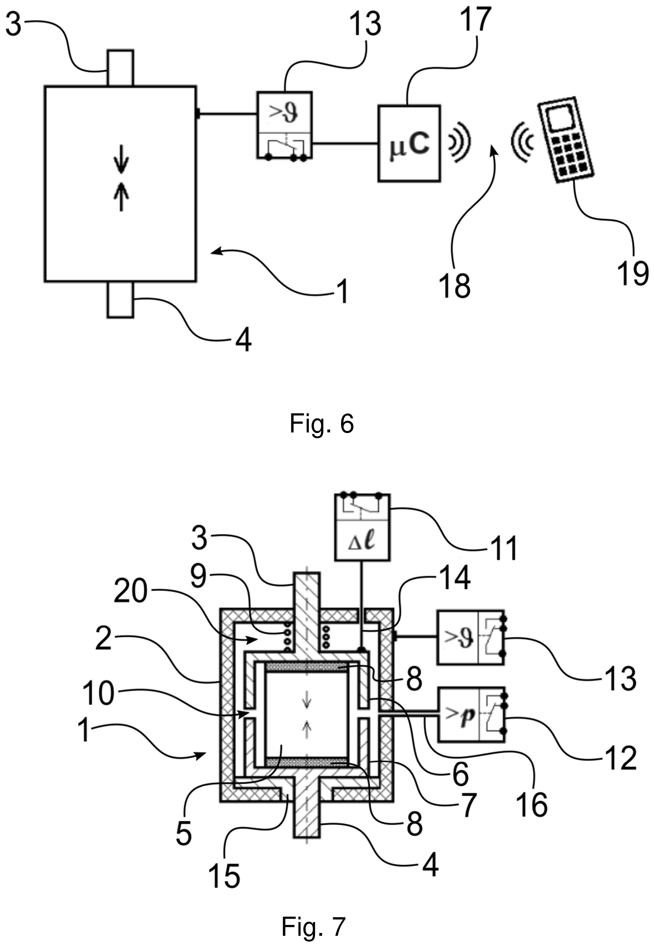

In the third exemplary embodiment shown in fig. 5 and fig. 6, the voltage limiter 1 is implemented in the same manner as in the first exemplary embodiment, with the difference that, instead of the position sensor 11, it comprises a temperature sensor 13, wherein the evaluation unit 17 is connected to this temperature sensor 13. Thus, the temperature sensor 13 and the evaluation unit 17 together form the functional status monitoring device.

In this exemplary embodiment, the temperature sensor 13 indicates the temperature on the external surface of the housing 2, specifically by the temperature sensor 13 being a thermal fusible fuse that is connected by its output leads to the external surface of the housing 2 and to the input of the evaluation unit 17.

In the case of a thermal or current load of the voltage limiter 1, the protective element 5 generates a large amount of heat causing the temperature of the at least one fusible element 8 to rise rapidly to its liquid temperature (melting temperature) and cause it to melt. The action of the elastic element 9 subsequently results in the displacement of the movable electrode 6 into contact with the fixed electrode 7, and thus in the creation of an alternate current path that bridges the protective element 5 and thus prevents its explosion or other uncontrollable failure. However, the heat generated by the protective element 5 when it is loaded also heats the other parts of the voltage limiter 1 and the temperature inside the housing 2 and on the external surface of the housing 2 increases. Thus, a short circuit of the short-circuiting device is not only indicated by the melting of the at least one fusible element 8 but also by an increase in the temperature on the external surface of the housing 2 above the value at which the fusible element in the thermal fusible fuse melts. This is also indicated by the ">ϑ" designation in fig. 5 and fig. 6.

The fusing temperature of the fusible fuse is chosen to be approximately the same as the fusing temperature of the at least one fusible element 8, or slightly lower with respect to the arrangement of the voltage limiter 1. At the moment of a short circuit the temperature on the external surface of the housing 2 will be slightly lower than the temperature inside the housing 2, e.g., in the space between the movable electrode 6 and the fixed electrode 7.

In the described exemplary embodiment, the evaluation unit 17 is a microcontroller. In this exemplary embodiment, the microcontroller comprises an RFID chip with at least one input for connecting at least the temperature sensor 13, and further also comprises a transmitter that provides information about the functional status of the voltage limiter 1, i.e., whether an overload of the protective element 5 and a short circuit of the short-circuiting device have occurred. As an example, the microcontroller is programmed such that when its input, to which the output of the temperature sensor 13 is connected, is in a low impedance status ("Closed" status), the output of the microcontroller is information that the functional status of the voltage limiter 1 is "OK". If, on the other hand, its input, to which the output of the temperature sensor 13 is connected, is in a high impedance status ("Open" status), the output of the microcontroller is information that the functional status of the voltage limiter 1 is "NOK", which means that overload of the protective element 5 and a short circuit of the short-circuiting device have occurred. The high impedance at the input of the microcontroller indicates precisely the fact that the circuit was disconnected after the fusing temperature of the thermal fusible fuse was exceeded.

The received information about the functional status of the voltage limiter 1 is provided by the transmitter for its reception. In the exemplary embodiment, a reader 19 is used to receive this information, specifically an RFID reader, which is also shown in fig. 6 for greater clarity. In this exemplary embodiment, the reader 19 is connected to the evaluation unit 17 via a wireless connection 18, wherein the reader 19 comprises at least one status indicator, e.g., a light, for displaying the functional status of the voltage limiter 1 to the user.

### Example 4:

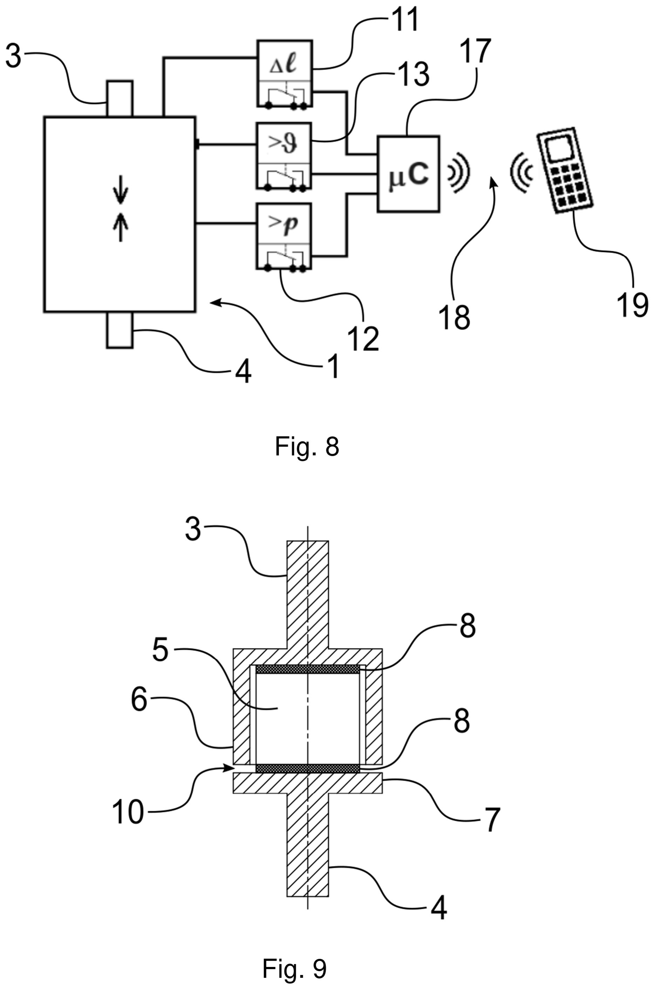

In the fourth exemplary embodiment shown in fig. 7 and fig. 8, the voltage limiter 1 is implemented in the same manner as in the first exemplary embodiment, with the difference that in addition to the position sensor 11 indicating the position of the movable electrode 6, the voltage limiter 1 also comprises the pressure sensor 12 indicating the pressure in the internal cavity 20 of the housing 2, implemented, for example, according to the second exemplary embodiment above, and also the temperature sensor 13 indicating the temperature on the external surface or inside the housing 2, implemented, for example, according to the third exemplary embodiment above. In this embodiment, the evaluation unit 17 is associated with the position sensor 11, the pressure sensor 12, and the temperature sensor 13, wherein the position sensor 11, the pressure sensor 12, the temperature sensor 13, and the evaluation unit 17 together form the functional status monitoring device.

In the described exemplary embodiment, the evaluation unit 17 is a microcontroller. In this exemplary embodiment, the microcontroller comprises an RFID chip having at least one input for connecting the position sensor 11, at least one input for connecting the pressure sensor 12, and at least one input for connecting the temperature sensor 13. The microcontroller further comprises a transmitter that provides information about the functional status of the voltage limiter 1, i.e., whether overload of the protective element 5 and a short circuit of the short-circuiting device have occurred.

As an example, the microcontroller is programmed such that when the input for connecting the position sensor 11 to which the output of the position sensor 11 is connected is in the high impedance status ("Open" status), the input for connecting the pressure sensor 12, to which the output of the pressure sensor 12 is connected, is in the high impedance status ("Open" status), and simultaneously the input for connecting the temperature sensor 13, to which the output of the temperature sensor 13 is connected, is in the low impedance status ("Closed" status), the output of the microcontroller is information that the functional status of the voltage limiter 1 is "OK". On the other hand, when at least the input for connecting the position sensor 11 to which the output of the position sensor 11 is connected is in the low impedance status ("Closed" status), if at least the input for connecting the pressure sensor 12, to which the output of the pressure sensor 12 is connected, is in the low impedance status ("Closed" status), or if at least the input for connecting the temperature sensor 13, to which the output of the temperature sensor 13 is connected, is in the high impedance status ("Open" status), the output of the microcontroller is information that the functional status of the voltage limiter 1 is "NOK", which means that overload of the protective element 5 and a short circuit of the short-circuiting device have occurred.

The received information about the functional status of the voltage limiter 1 is provided by the transmitter for its reception. In the exemplary embodiment, a reader 19 is used to receive this information, specifically an RFID reader, which is also shown in fig. 8 for greater clarity. In this exemplary embodiment, the reader 19 is connected to the evaluation unit 17 via a wireless connection 18, wherein the reader 19 comprises at least one status indicator, e.g., a light, for displaying the functional status of the voltage limiter 1 to the user.

Further, the voltage limiter 1 with the integrated short-circuiting device and with the functional status monitoring device may be implemented in many other alternative embodiments that arise, e.g., from the alternatives listed in the section "Summary of the invention". Thus, where possible, the individual exemplary embodiments may be combined with each other. Some alternative embodiments are listed below.

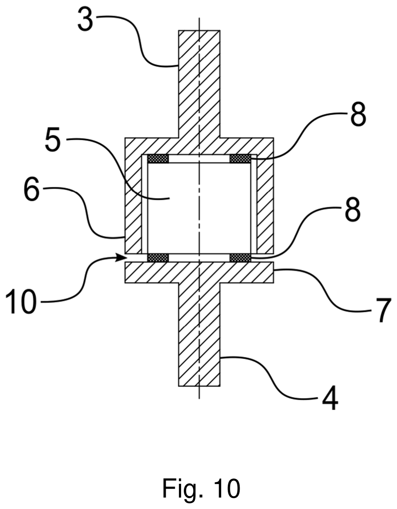

In one alternative exemplary embodiment, the movable electrode 6 has the shape of a hollow cylinder with one face and the fixed electrode 7 has the shape of a solid cylinder, as shown in fig. 9 or fig. 10.

In another alternative embodiment, at least one fusible element 8 has the shape of a flat cylinder with a base in the shape of an annulus, as shown in fig. 10. Fig. 10 specifically shows an embodiment that combines a feature of this alternative exemplary embodiment with a feature of the preceding alternative exemplary embodiment.

In another alternative exemplary embodiment, the link 14 between the position sensor 11 and the movable electrode 6 is implemented by a magnet, e.g., a neodymium magnet, wherein the contact of the position sensor 11 is magnetically controlled.

In a further alternative exemplary embodiment, the thermal fusible fuse is connected by its output leads to the internal surface of the housing 2 and to the input of the evaluation unit 17.

### Industrial Applicability

The above described voltage limiter with an integrated short-circuiting device and a functional status monitoring device finds application wherever it is necessary to eliminate impermissible high contact voltage on non-live metal parts and to ensure a permanent checking of the functionality of the voltage limiters, for example in rail transport. It can also be used to increase the operational reliability of surge protectors installed in low-voltage and high-voltage AC/DC networks and photovoltaic power plant systems.

### List of Reference Signs

- 1 -: voltage limiter
- 2 -: housing
- 3 -: first connecting terminal
- 4 -: second connecting terminal
- 5 -: protective element
- 6 -: movable electrode
- 7 -: fixed electrode
- 8 -: fusible element
- 9 -: elastic element
- 10 -: insulating gap
- 11 -: position sensor
- 12 -: pressure sensor
- 13 -: temperature sensor
- 14 -: link between the position sensor and the movable electrode
- 15 -: insulating insert
- 16 -: outlet
- 17 -: evaluation unit
- 18 -: wireless connection
- 19 -: reader
- 20 -: internal cavity

## Claims

1. A voltage limiter (1) with an integrated short-circuiting device and a functional status monitoring device, wherein the voltage limiter (1) comprises a housing (2) with an internal cavity (20), further a first connecting terminal (3) and a second connecting terminal (4) which lead out of the housing (2), and a short-circuiting device disposed inside the housing (2), wherein the short-circuiting device comprises a protective element (5), a movable electrode (6), a fixed electrode (7), and at least one fusible element (8) connecting the protective element (5) to the movable electrode (6) or the fixed electrode (7), wherein the protective element (5) is electrically conductively connected to the first connecting terminal (3) and the second connecting terminal (4), the movable electrode (6) is electrically conductively connected to the first connecting terminal (3), and the fixed electrode (7) is electrically conductively connected to the second connecting terminal (4), wherein the movable electrode (6) is movable relative to the fixed electrode (7) between a first position, in which the movable electrode (6) and the fixed electrode (7) are mutually separated by an insulating gap (10), and a second position, in which the movable electrode (6) and the fixed electrode (7) are in mutual contact, **characterized in that** the voltage limiter (1) further comprises a functional status monitoring device, wherein the functional status monitoring device comprises at least one sensor from a group comprising a position sensor (11) indicating the position of the movable electrode (6), a pressure sensor (12) indicating the pressure in the internal cavity (20) of the housing (2), and a temperature sensor (13) indicating the temperature on the external surface or inside the housing (2), wherein the functional status monitoring device further comprises an evaluation unit (17) connected to at least one sensor and adapted to provide information about the functional status of the voltage limiter (1) based on the output of the at least one sensor, wherein the information about the functional status of the voltage limiter (1) is information about whether an overload of the protective element (5) and a short circuit of the short-circuiting device have occurred.

2. The voltage limiter (1) according to claim 1, **characterized in that** the functional status monitoring device comprises at least one position sensor (11) indicating the position of the movable electrode (6), at least one pressure sensor (12) indicating the pressure in the internal cavity (20) of the housing (2), and at least one temperature sensor (13) indicating the temperature on the external surface or inside the housing (2).

3. The voltage limiter (1) according to any one of the preceding claims, **characterized in that** the functional status monitoring device comprises at least one position sensor (11), wherein the position sensor (11) is connected to the movable electrode (6) by a link (14) between the position sensor (11) and the movable electrode (6).

4. The voltage limiter (1) according to any one of the preceding claims, **characterized in that** the functional status monitoring device comprises at least one pressure sensor (12), wherein the pressure sensor (12) is connected to the internal cavity (20) via an outlet (16).

5. The voltage limiter (1) according to any one of the preceding claims, **characterized in that** the functional status monitoring device comprises at least one temperature sensor (13), wherein the temperature sensor (13) is a thermal fusible fuse.

6. The voltage limiter (1) according to any one of the preceding claims, **characterized in that** the evaluation unit (17) comprises a transmitter for providing information about the functional status of the voltage limiter (1), wherein the functional status monitoring device further comprises a reader (19) for receiving information about the functional status of the voltage limiter (1) provided by the transmitter.

7. The voltage limiter (1) according to claim 6, **characterized in that** the evaluation unit (17) comprises an RFID chip and the reader (19) is an RFID reader.
